# FASCICULE DE BREVET EUROPEEN

(11) **EP 1 644 969 B1**
(45) Date de publication et mention de la délivrance du brevet: **12.05.2010**
(21) Numéro de dépôt: 04767657.2
(22) Date de dépôt: 12.07.2004
(51) Int. Cl.: H01L 21/265, H01L 21/762

(54) **PROCEDE D'IMPLANTATION AU TRAVERS D'UNE SURFACE IRREGULIERE**
VERFAHREN ZUR IMPLANTATION DURCH EINE IRREGULÄRE OBERFLÄCHE
METHOD FOR IMPLANTATION THROUGH AN IRREGULAR SURFACE

(30) Priorité: 10.07.2003 FR 0308462
(43) Date de publication de la demande: 12.04.2006
(73) Titulaire: S.O.I.Tec Silicon on Insulator Technologies, 38190 Bernin (FR)
(72) Inventeur: GHYSELEN, Bruno, F-38170 Seyssinet-Pariset (FR); AKATSU, Takeshi, F-38330 Saint-Nazaire-Les-Eymes (FR); FONTANIERE, Richard, F-38400 Saint Martin d´Here (FR)
(74) Mandataire: Collin, Jérôme
(86) Numéro de dépôt international: PCT/FR2004/001826
(87) Numéro de publication internationale: WO 2005/008756

(56) Documents cités:
- US-B1- 6 274 439
- PATENT ABSTRACTS OF JAPAN vol. 016, no. 472 (E-1272), 30 septembre 1992 (1992-09-30) -& JP 04 168764 A (NEC YAMAGATA LTD), 16 juin 1992 (1992-06-16)

## Description

La présente invention concerne le traitement de tranches de matériaux choisis parmi les matériaux semiconducteurs, notamment pour des applications en électronique, microélectronique, optoélectronique.

Plus précisément, l'invention concerne un procédé d'implantation dans une tranche comprenant au moins une couche présentant une surface irrégulière, ladite implantation traversant ladite surface irrégulière.

Il est connu de mettre en oeuvre des procédés d'implantation dans des tranches de matériaux choisis parmi les matériaux semiconducteurs, pour obtenir divers effets.

Le document US6,274,439 envisage ainsi une implantation pour modifier les propriétés d'un transistor.

On peut par ailleurs désirer créer par l'implantation une zone fragilisée dans l'épaisseur de la tranche.

Le procédé SMARTCUT^{®} met ainsi en oeuvre une telle implantation. permettant de créer une zone de fragilisation.

On trouvera une description générale du procédé SMARTCUT® dans «Silicon-On-Insulator Technology : Materials to VLSI, 2^{nd} Edition» de Jean-Pierre Colinge_chez « Kluwer Académic Publishers », p.50 et 51.

Dans le cas où on souhaite créer une zone de fragilisation dans l'épaisseur de la tranche - par exemple dans le cadre d'un procédé de type SMARTCUT^{®}), il est généralement désiré que ladite zone soit régulière en s'étendant sensiblement dans un même plan.

Et de manière plus générale, dans de nombreuses applications de l'implantation, il est désiré de réaliser l'implantation de sorte que les espèces implantées se répartissent dans l'épaisseur de la tranche selon une distribution régulière, avec la même profondeur d'implantation sous le niveau moyen de la surface de la tranche.

Or, le fait d'implanter à travers une surface irrégulière perturbe l'uniformité de la profondeur d'implantation des espèces.

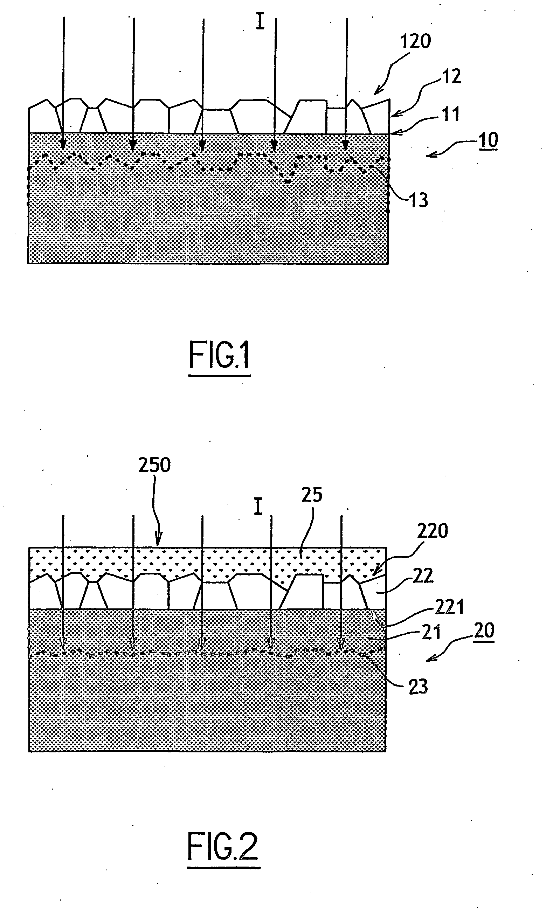

Cet effet est illustré sur la figure 1.

Cette figure illustre une implantation d'espèces dans une tranche 10, au travers d'une couche 12 de matériau présentant une surface irrégulière 120 et d'une partie du substrat 11 sur laquelle la couche 12 est située.

On précise qu'on entend dans ce texte « surface irrégulière » une surface présentant une rugosité et une planéité supérieure à une valeur de l'ordre de quelques angströms en rms (correspondant à l'acronyme anglosaxon de root mean square). Un Angström équivaut à 0,1nm.

Par opposition, dans le présent texte une surface sera dite régulière si sa rugosité est inférieure à cette valeur.

On constate que du fait du caractère irrégulier de la surface 120, la profondeur d'implantation (représentée par la ligne 13) est également irrégulière.

Ceci constitue un inconvénient.

Un but de l'invention est de pallier à cet inconvénient.

Afin d'atteindre ce but, l'invention propose un procédé d'implantation tel que revendiqué dans la revendication 1.

D'autres aspects, buts et avantages de l'invention apparaîtront mieux à la lecture de la description suivante de l'invention faite en référence aux dessins annexés sur lesquels, outre la figure 1 qui a déjà été commentée ci-dessus :
o La figure 2 illustre l'effet sur l'uniformité de profondeur d'implantation de la mise en oeuvre d'une couche de recouvrement, préalablement à l'implantation,
• La figure 3 présente des résultats de simulations illustrant les effets sur la profondeur locale d'implantation de l'épaisseur de la couche de recouvrement, ainsi que de la planarisation de cette couche de recouvrement,
• La figure 4 est un graphe mettant en évidence les différences de coefficients de profondeur d'implantation de différents matériaux, pour une implantation par de l'hydrogène.

La figure 2 représente une tranche 20 qui comprend une couche 22 présentant une surface irrégulière 220, sur une couche de substrat 21.

On remarque qu'une couche 25 recouvre la surface irrégulière 220.

La couche 22 peut être par exemple en diamant CVD, en Si3N4, en AlN, ou encore en un matériau polycristallin tel que notamment du silicium polycristallin.

De tels matériaux sont rugueux. Ils peuvent par exemple être mis en oeuvre dans une tranche de type SOI (Silicon On Insulator, pour silicium sur isolant), par exemple pour améliorer les propriétés de conductivité thermique d'une telle tranche.

Il peut ainsi être désiré de constituer la couche d'isolant d'une telle tranche non pas en SiO2 (dont les propriétés de conductivité thermique ne sont pas bonnes), mais par un ou plusieurs matériaux qui possèdent une haute conductivité thermique, comme le diamant ou le Si3N4.

Des couches de tels matériaux sont généralement obtenues par épitaxie. Mais la surface de telles couches épitaxiées est irrégulière.

Le matériau de la couche 22 est typiquement un matériau présentant une dureté importante (cas du diamant par exemple), ou délicat à polir uniformément car hétérogène (exemple des matériaux polycristallins), et de ce fait difficile à polir - ou de manière générale à planariser.

Il peut en particulier s'agir d'un matériau dont le prix de revient est élevé, et pour lequel on souhaite minimiser tant que possible les pertes de matière.

La couche 22 peut avoir été obtenue par dépôt sur la surface plane de la couche 21 de substrat.

Un tel dépôt peut par exemple avoir été réalisé par une technique du type CVD (acronyme de l'appellation anglo-saxonne répandue Chemical Vapor Deposition pour dépôt chimique sous vide).

On remarquera que de la sorte la couche 22 est une couche dont la surface 220 est certes irrégulière, mais dont l'autre face 221 à l'interface avec le substrat 21 est quant à elle plane.

La face du substrat 21 qui reçoit le dépôt de la couche 22 est en effet elle-même plane.

Dans le mode de mise en oeuvre de l'invention représenté sur cette figure, la tranche 20 est une tranche multicouche, c'est-à-dire qu'elle est composée de plusieurs couches (en l'occurrence couche 22 + couche 21 de substrat).

On notera toutefois qu'il est possible de mettre en oeuvre l'invention pour réaliser une implantation uniforme dans une tranche monocouche à surface irrégulière, ou à l'intérieur même d'une couche présentant une surface irrégulière et située sur ou dans une tranche multicouche.

Revenant au mode de mise en oeuvre de l'invention illustré sur la figure 2, la tranche 20 comporte ainsi en dessous de la couche 22 une couche 21, que l'on nommera substrat.

Et dans ce mode de mise en oeuvre de l'invention, l'implantation est réalisée de manière à traverser la couche 22 présentant une surface irrégulière, pour constituer dans l'épaisseur du substrat 21 une zone 23 correspondant au maximum de concentration des espèces implantées.

Cette couche de recouvrement a été associée à la tranche 20 avant l'implantation.

Ceci a en particulier pu être réalisé par dépôt du matériau de la couche de recouvrement 25.

On remarquera que la surface 250 de la couche de recouvrement 25 est plane.

Ceci peut être obtenu en particulier en réalisant un traitement de cette surface 250.

Un tel traitement peut ainsi inclure un traitement de planarisation, mettant en oeuvre par exemple un polissage.

On constate sur la figure 2 que la zone 23 est beaucoup plus régulière que la zone 13 de la figure 1.

Le fait d'avoir recouvert par une couche présentant une surface plane la surface irrégulière de la couche 22, avant l'étape d'implantation, permet en effet de réaliser ensuite cette implantation avec une profondeur d'implantation dont l'uniformité est sensiblement augmentée.

Dans le cadre de la création d'une zone de fragilisation correspondant à la zone 23 qui présente un maximum de concentration d'espèces implantées, on peut de la sorte réaliser par implantation une zone de fragilisation 23 régulière, tout en effectuant cette implantation au travers d'une couche 22 de surface irrégulière.

L'invention est ainsi mise en oeuvre avec profit dans le cadre d'un procédé de type SMARTCUT^{®}. Suite à l'implantation on met en oeuvre les étapes principales suivantes :
- Collage de la surface 250 avec un raidisseur,
- Détachement du substrat 21 au niveau de la zone 23,
- Eventuellement traitement de la surface libre ainsi créée au niveau de cette zone 23.

On précise en outre qu'il est possible, avant le collage, d'intercaler une fine couche électriquement isolante entre la surface 250 et le raidisseur.

Ceci peut être fait par exemple par dépôt d'une couche électriquement isolante - par exemple en SiO2 - sur la surface 250.

Dans un tel cas, on peut assimiler la réunion de la couche 25 et de la couche supplémentaire qui lui a été superposée, à la couche de recouvrement.

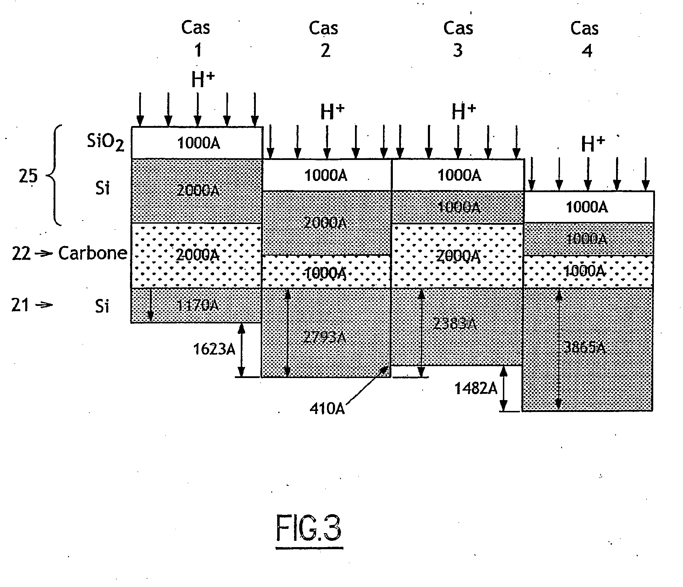

La fine couche isolante mentionnée ci-dessus peut être déposée avant l'implantation sur le matériau de recouvrement qui est déjà présent au-dessus de la surface 220, de sorte que ladite fine couche participe alors à la constitution de la couche 25 (voir à cet égard les cas illustrés sur la figure 3).

Et de manière générale, la couche de recouvrement 25 peut être constituée de plusieurs couches de matériaux différents. On reviendra sur cet aspect dans la suite de ce texte.

Le substrat 21 peut être en silicium monocristallin.

L'implantation peut être réalisée avec de l'hydrogène et/ou de l'hélium.

La figure 3 illustre l'effet sur la profondeur locale d'implantation de l'épaisseur de la couche de recouvrement, ainsi que de la planarisation de cette couche de recouvrement.

Cette couche représente pour quatre conditions locales d'implantation la profondeur d'implantation, au travers d'une couche de recouvrement 25 et d'une couche à surface irrégulière 22, dans l'épaisseur d'un substrat 21 (ces références 21, 22, 25 correspondant aux différentes couches illustrées sur la figure 2).

Ces résultats sont issus de simulations menées par la demanderesse.

Dans ces simulations :
- la couche 21 avait les caractéristiques du silicium monocristallin,
- la couche 22 avait les caractéristiques du carbone - et correspondait ainsi à la couche présentant une surface irrégulière (le carbone correspondant au diamant),
- la couche 25 était composée de deux couches :
   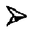 une couche de silicium déposée sur la surface irrégulière de la couche 22 de carbone (les irrégularités de cette couche correspondant sur la figure 3 aux différentes épaisseurs de carbone dans les différentes simulations),
   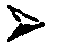 et une couche de SiO2 recouvrant la couche de silicium.

Les quatre simulations de la figure 3 correspondent à quatre conditions d'implantation avec de l'hydrogène :
- le cas 1 correspond à une épaisseur de carbone de 2 000 angströms, recouverte de 2 000, angströms de silicium et de 1 000 angströms de SiO2. Dans ce cas, la profondeur d'implantation dans le silicium du substrat 21 est de 1 170 angströms,
- le cas 2 correspond à une épaisseur de carbone de 1 000 angströms, recouverte de 2 000 angströms de silicium et de 1 000 angströms de SiO2. Dans ce cas, la profondeur d'implantation dans le silicium du substrat 21 est de 2 793 angströms,
- le cas 3 correspond à une épaisseur de carbone de 2 000 angströms, recouverte de 1 000 angströms de silicium et de 1 000 angströms de SiO2. Dans ce cas, la profondeur d'implantation dans le silicium du substrat 21 est de 2 383 angströms,
- le cas 4-correspond à une épaisseur de carbone de 1 000 angströms, recouverte de 1 000 angströms de silicium et de 1 000 angströms de SiO2. Dans ce cas, la profondeur d'implantation dans le silicium du substrat 21 est de 3 865 angströms.

On précise que les conditions d'implantation (dose, énergie, ...) sont les mêmes dans les quatre cas.

Ces résultats illustrent plusieurs phénomènes :
- premièrement, partant d'une surface irrégulière, lorsqu'on implante à travers une surface de couche 22 qui présente une irrégularité, et une couche de recouvrement qui est la même pour les différents endroits de cette surface, l'irrégularité de la couche 22 est non seulement reproduite mais même amplifiée. Ceci est illustré :
   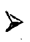 par la comparaison des cas 1 et 2 qui montre une différence de 1 623 angströms dans la profondeur d'implantation, à partir d'une différence initiale de 1 000 angströms d'épaisseur de la couche de carbone,
   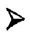 par la comparaison des cas 3 et 4 qui montre une différence de 1 482 angströms dans la profondeur d'implantation, à partir d'une différence initiale de 1 000 angströms d'épaisseur de la couche de carbone,
- deuxièmement, dans le cas où partant d'une surface de la couche 22 irrégulière, on effectue une planarisation de la couche 25 de recouvrement, la différence de profondeur d'implantation est très sensiblement réduite :
   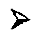 la comparaison des cas 2 et 3 illustre ainsi une différence de 410 angströms seulement dans la profondeur d'implantation, en partant d'une différence de 1 000 angströms pour l'épaisseur de la couche 22. La comparaison des cas 2 et 3 correspond à une situation dans laquelle la couche de silicium qui contribue à former la couche de recouvrement 25 a été planarisée avant le dépôt de la couche de SiO2 qui la recouvre. La comparaison de ces deux cas illustre ainsi le bénéfice d'une telle planarisation.

On comprend donc que pour réduire au maximum les différences de profondeur d'implantation générées par les différences d'épaisseur de la couche 22, un recouvrement avec planarisation est particulièrement avantageux.

On précise également qu'il est possible selon une variante de mise en oeuvre de l'invention d'adapter localement l'épaisseur de la couche de recouvrement 25, en différents endroits de la tranche, pour adapter sélectivement en conséquence la profondeur d'implantation, en vue d'augmenter encore son uniformité.

Cette adaptation locale de l'épaisseur de la couche de recouvrement 25 peut être réalisée au dépôt de cette couche, ou par des traitements ultérieurs (planarisation ou gravure chimique sélective, ...).

On a commenté en référence à la figure 3 la mise en oeuvre de l'invention avec le recouvrement par une couche 25 réalisée à base de Si et de SiO2.

Comme on va le voir, la nature du ou des matériau(x) utilisé(s) pour cette couche de recouvrement peut également avoir une influence sur les différences d'épaisseur d'implantation.

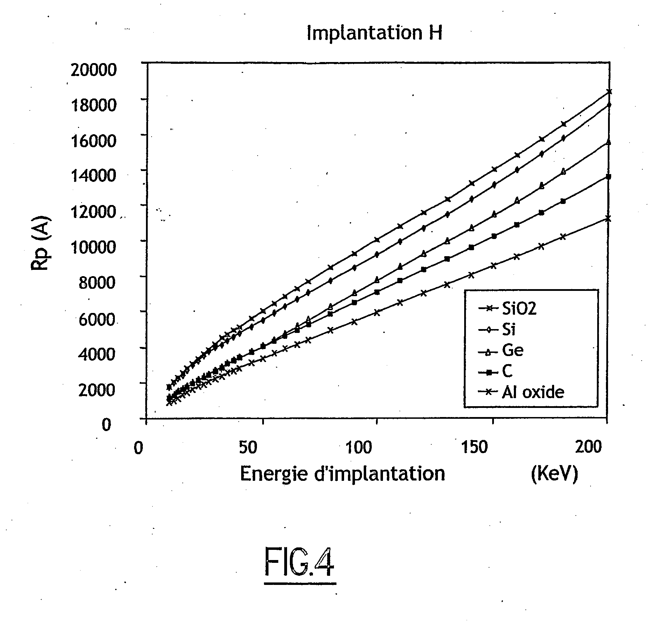

La figure 4 illustre ainsi la profondeur moyenne d'implantation (ordonnée Rp(A), en angströms) en fonction de l'énergie d'implantation (abscisse énergie d'implantation en keV), pour -une- implantation d'hydrogène dans différents matériaux.

Cette figure fait apparaître que pour les mêmes conditions d'implantation, la profondeur moyenne d'implantation est différente selon la nature du matériau implanté.

On peut ainsi caractériser chaque matériau par un coefficient de profondeur d'implantation qui lui est propre.

La figure 4 illustre ainsi que l'on peut classer les matériaux suivants par ordre décroissant de ce coefficient (c'est-à-dire que pour les mêmes condition d'implantation, le matériau ayant un coefficient plus élevé correspondra à une profondeur d'implantation supérieure) :
- SiO2,
- Si,
- Germanium,
- Carbone (diamant),
- Oxyde d'aluminium.

Ces différences de coefficient de profondeur d'implantation peuvent être avantageusement exploitées dans le cadre de l'invention.

La demanderesse a en effet mis en évidence qu'il était possible d'améliorer encore l'uniformité de l'implantation en effectuant le recouvrement avec une couche 25 réalisée en un ou plusieurs matériaux, dans laquelle chaque matériau présente un coefficient de profondeur d'implantation le plus proche possible du coefficient de profondeur d'implantation du matériau de la couche 22 qui présente une surface irrégulière.

En effectuant un recouvrement avec une telle couche 25, et en appliquant une planarisation (incluant de préférence un polissage) à cette couche de recouvrement, on se place dans les meilleures conditions pour réduire au maximum les différences dé profondeur d'implantation générées par les différences d'épaisseur de la couche 22.

On réalise en effet dans ce cas une « couche globale » composée de la superposition des couches 22 et 25. Cette couche globale a une épaisseur constante (du fait de la planarisation), et un coefficient de profondeur d'implantation le plus homogène possible.

On précise qu'il est également possible de combiner à l'intérieur de la couche 25 plusieurs couches de matériaux différents de sorte que la moyenne des coefficients de profondeur d'implantation de ces différents matériaux corresponde à la valeur du coefficient de profondeur d'implantation de la couche 22 irrégulière à recouvrir.

La « moyenne » mentionnée ci-dessus peut être pondérée par les épaisseurs respectives des différentes couches composant la couche 25.

## Revendications

1. Procédé d'implantation dans une tranche 20 comprenant au moins une couche 22 présentant une surface irrégulière (220), ladite implantation traversant ladite surface irrégulière, l'implantation visant à constituer une zone de maximum de concentration des espèces implantées qui correspond à une zone 23 de fragilisation , le procédé comprenant préalablement à l'étape d'implantation une étape de recouvrement de ladite surface irrégulière (220) par une couche de recouvrement (25), pour augmenter l'uniformité de la profondeur d'implantation, **caractérisé en ce que** suite à l'implantation on met en oeuvre un procédé de type SMARTCUT®.

2. Procédé selon la revendication précédente, **caractérisé en ce que** la tranche 20 est une tranche multicouche comprenant au moins un substrat (21) et ladite couche (22) présentant une surface irrégulière 220 .

3. Procédé selon l'une des revendications précédentes, **caractérisé en ce que** l'implantation est réalisée de manière à traverser la couche (22) présentant une surface irrégulière.

4. Procédé selon l'une des revendications précédentes, **caractérisé en ce que** la couche de recouvrement (25) est déposée sur ladite surface irrégulière (220).

5. Procédé selon l'une des revendications précédentes, **caractérisé en ce que** la nature du (des) matériau(x) de recouvrement est choisie de manière à augmenter l'uniformité de la profondeur d'implantation.

6. Procédé selon la revendication précédente, **caractérisé en ce que** le choix du (des) matériau(x) de recouvrement est effectué de manière à minimiser la différence entre les coefficients de profondeur d'implantation du matériau de la couche 22 présentant une surface irrégulière, et du (des) matériau(x) de recouvrement.

7. Procédé selon l'une des revendications précédentes, **caractérisé en ce que** lors de l'étape de recouvrement on réalise la couche de recouvrement 25 de manière à conférer à cette couche une surface plane.

8. Procédé selon l'une des revendications précédentes, **caractérisé en ce que** lors de l'étape de recouvrement on réalise un traitement de la surface de la couche de recouvrement (25).

9. Procédé selon la revendication précédente, **caractérisé en ce que** ledit traitement est un traitement de planarisation.

10. Procédé selon la revendication précédente, **caractérisé en ce que** ledit traitement comprend un polissage.

11. Procédé selon l'une des revendications précédentes, **caractérisé en ce que** l'implantation est réalisée avec de l'hydrogène et/ou de l'hélium.

12. Procédé selon l'une des revendications précédentes, **caractérisé en ce que** la couche 22 de matériau présentant une surface irrégulière est réalisée en un des matériaux suivants : diamant, Si3N4, AIN, silicium polycristallin.

## Claims

1. Method of implantation in a wafer (20) comprising at least one layer (22) having an irregular surface (220), said implantation passing through said irregular surface, the aim of the implantation being to form a zone of maximum concentration of the implanted species that corresponds to a weakened zone (23), the method including, prior to the implantation step, a step in which said irregular surface (220) is coated with a coating layer (25) in order to increase the uniformity of the implantation depth, **characterized in that** a SmartCut^{®} process is carried out after the implantation.

2. Method according to the preceding claim, **characterized in that** the wafer (20) is a multilayer wafer that includes at least one substrate (21) and said layer (22) having an irregular surface (220).

3. Method according to one of the preceding claims, **characterized in that** the implantation is carried out so as to pass through the layer (22) having an irregular surface.

4. Method according to one of the preceding claims, **characterized in that** the coating layer (25) is deposited on said irregular surface (220).

5. Method according to one of the preceding claims, **characterized in that** the nature of the coating material(s) is chosen so as to increase the uniformity of the implantation depth.

6. Method according to the preceding claim, **characterized in that** the choice of coating material(s) is made so as to minimize the difference between the implantation depth coefficient of the material of the layer (22) having an irregular surface and the implantation depth coefficient of the coating material(s).

7. Method according to one of the preceding claims, **characterized in that**, during the coating step, the coating layer (25) is produced so as to give this layer a plane surface.

8. Method according to one of the preceding claims,
**characterized in that**, during the coating step, a treatment of the surface of the coating layer (25) is carried out.

9. Method according to the preceding claim, **characterized in that** said treatment is a planarization treatment.

10. Method according to the preceding claim, **characterized in that** said treatment includes a polishing operation.

11. Method according to one of the preceding claims, **characterized in that** the implantation is carried out with hydrogen and/or helium.

12. Method according to one of the preceding claims, **characterized in that** the layer (22) of material having an irregular surface is made of one of the following materials: diamond, Si₃N₄, AlN, polycrystalline silicon.

## Patentansprüche

1. Verfahren zur Implantation in eine Platte (20), die mindestens eine Schicht (22) umfasst, welche eine unregelmäßige Oberfläche (220) aufweist, wobei die Implantation die unregelmäßige Oberfläche durchquert, die Implantation darauf abzielt, eine Zone maximaler Konzentration der implantierten Spezies aufzubauen, welche einer Versprödungszone (23) entspricht, das Verfahren vor dem Schritt der Implantation einen Schritt der Bedeckung der unregelmäßigen Oberfläche (220) durch eine Abdeckschicht (25) umfasst, um die Gleichförmigkeit der Implantationstiefe zu steigern, **dadurch gekennzeichnet, dass** nach der Implantation ein Verfahren vom Typ SMARTCUT^{®} durchgeführt wird.

2. Verfahren nach dem vorangehenden Anspruch, **dadurch gekennzeichnet, dass** die Platte (20) eine mehrlagige Platte ist, die mindestens ein Substrat (21) und die eine unregelmäßige Oberfläche (220) aufweisende Schicht (22) umfasst.

3. Verfahren nach einem der vorangehenden Ansprüche, **dadurch gekennzeichnet, dass** die Implantation so durchgeführt wird, dass die eine unregelmäßige Oberfläche aufweisende Schicht (22) durchquert wird.

4. Verfahren nach einem der vorangehenden Ansprüche, **dadurch gekennzeichnet, dass** die Bedeckungsschicht (25) auf der unregelmäßigen Oberfläche (220) abgeschieden wird.

5. Verfahren nach einem der vorangehenden Ansprüche, **dadurch gekennzeichnet, dass** die Natur des Bedeckungsmaterials bzw. der Bedeckungsmaterialien so gewählt ist, dass die Gleichförmigkeit der Implantationstiefe gesteigert wird.

6. Verfahren nach dem vorangehenden Anspruch, **dadurch gekennzeichnet, dass** die Wahl des Bedeckungsmaterials bzw. der Bedeckungsmaterialien so getroffen wird, dass der Unterschied zwischen den Koeffizienten der Implantationstiefe des Materials der eine unregelmäßige Oberfläche (220) aufweisenden Schicht (22) und des Bedeckungsmaterials bzw. der Bedeckungsmaterialien minimiert wird.

7. Verfahren nach einem der vorangehenden Ansprüche, **dadurch gekennzeichnet, dass** während des Schritts der Bedeckung die Bedeckungsschicht (25) so hergestellt wird, dass dieser Schicht eine ebene Oberfläche verliehen wird.

8. Verfahren nach einem der vorangehenden Ansprüche, **dadurch gekennzeichnet, dass** während des Schritts der Bedeckung eine Behandlung der Oberfläche der Bedeckungsschicht (25) durchgeführt wird.

9. Verfahren nach dem vorangehenden Anspruch, **dadurch gekennzeichnet, dass** die Behandlung eine Einebnungsbehandlung ist.

10. Verfahren nach dem vorangehenden Anspruch, **dadurch gekennzeichnet, dass** die Behandlung ein Polieren umfasst.

11. Verfahren nach einem der vorangehenden Ansprüche, **dadurch gekennzeichnet, dass** die Implantation mit Wasserstoff und/oder Helium durchgeführt wird.

12. Verfahren nach einem der vorangehenden Ansprüche, **dadurch gekennzeichnet, dass** die eine unregelmäßige Oberfläche aufweisende Materialschicht (22) aus einem der folgenden Materialien hergestellt ist: Diamant, Si3N4, AIN, polykristallinem Silicium.
